# EUROPÄISCHE PATENTANMELDUNG

(11) **EP 4 154 995 A1**
(43) Veröffentlichungstag der Anmeldung: **29.03.2023**
(21) Anmeldenummer: 21198604.7
(22) Anmeldetag: 23.09.2021
(51) Int. Cl.: B05C 11/02, H05K 1/03, H05K 3/12, B29C 64/209, B22F 12/53, B23K 26/14, B05C 5/02

(54) **EINHEIT ZUM AUFTRAGEN UND ABSTREIFEN VON MATERIAL**

(71) Anmelder: Siemens Aktiengesellschaft, 80333 München (DE)
(72) Erfinder: Jähnicke, Jens, 09112 Chemnitz (DE)
(74) Vertreter: Siemens Patent Attorneys

(57) **Zusammenfassung**

Die Erfindung betrifft eine Einheit (30) zum Auftragen und Abstreifen von Material (2), aufweisend:
- eine Auftragevorrichtung mit einer Düse (3) zum Heraustreiben des Materials (2) aus einem Reservoir (5),
- eine Grundfläche (10), ausgebildet zur Ablage des Materials (2),
- eine Abstreifplatte (100), wobei die Abstreifplatte (100) die Düse (3) tangiert.

## Beschreibung

Die Erfindung betrifft eine Einheit zum Auftragen und Abstreifen von Material.

Ein bekanntes Verfahren zum Aufbau von Werkstücken mittels 3D-Drucks ist Fused Deposition Modeling (FDM; deutsch: Schmelzschichtung oder auch Fused Filament Fabrication (FFF)). Dies ist eine Fertigungsverfahren, bei welchem ein Werkstück schichtweise aus einem schmelzfähigen Kunststoff oder auch Metall aufgebaut wird.

Das Werkstück wird hierbei aufgebaut, indem das jeweilige Material erwärmt und das so verflüssigte Material durch Extrudieren mittels einer Düse auf eine Unterlage aufgebracht wird. Anschließend erfolgt eine Erhärtung.

Bei diesem Verfahren ist jedoch nachteilig, dass keine definierte, glatte Oberfläche geschaffen werden kann. Das erhärtete Material weist durch die Extrusion eine gewölbte Oberfläche auf.

Der Erfindung liegt die Aufgabe zugrunde, dies zu verbessern.

Die Lösung der Aufgabe gelingt durch Anspruch 1, d. h. eine Einheit zum Auftragen und Abstreifen von Material, aufweisend:
- eine Auftragevorrichtung mit einer Düse zum Heraustreiben des Materials aus einem Reservoir,
- eine Grundfläche, ausgebildet zur Ablage des Materials,
- eine Abstreifplatte, wobei die Abstreifplatte die Düse tangiert.

Vorteilhaft wird das Material, beispielsweise im Reservoir, durch wenigstens ein Heizelement erwärmt. Das Material wird auf diese Weise vorzugsweise verflüssigt.

Die Grundfläche kann ein Substrat sein.

Die Lösung gelingt ferner durch eine Abstreifplatte für eine derartige Einheit, aufweisend Glas, insbesondere Quarzglas und/oder Keramik und/oder Metall.

Die Abstreifplatte weist vorteilhaft ein schlecht wärmeleitendes Material auf. Dies ist von Vorteil, da so wenig Wärme wie möglich von der Düse auf die Abstreifplatte übertragen werden soll.

Die Abstreifeinheit kann gänzlich aus Glas und/oder Keramik bestehen.

Es ist jedoch auch möglich, dass die Abstreifeinheit Metall bzw. eine Metalllegierung aufweist und mit Glas und/oder Keramik beschichtet ist.

Die Abstreifplatte ist vorteilhaft wenigstens im Wesentlichen parallel zur Grundfläche angeordnet ist.

So kann eine gleichmäßige Oberfläche geschaffen werden. Zudem kann dadurch auch eine konstante Dicke bzw. ein konstanter Querschnitt des aufgetragenen Materials erreicht werden.

Die Abstreifplatte ist eine glatte Platte oder eine Platte mit Struktur.

Ist die Abstreifplatte glatt, kann eine spiegelglatte Oberfläche des aufgebrachten und erstarrten Materials erreicht werden.

Eine Platte mit Struktur kann beispielsweise Riefen aufweisen, sodass eine Oberfläche des aufgebrachten und erstarrten Materials vergrößert ist.

Werden beispielsweise Leiterbahnen in einem Schaltschrank gedruckt und abgestreift, kann durch die Gestaltabweichung der Oberfläche und die somit vergrößerte Oberfläche Wärme gut abgeführt werden.

Weitere Ausgestaltungen der Abstreifplatte sind in der Figurenbeschreibung erläutert.

Die Lösung der Aufgabe gelingt zudem durch ein Verfahren zum Auftragen und Abstreifen von Material mit einer derartigen Einheit, wobei aufgeschmolzenes Material durch eine Düse auf eine Grundfläche in einer Schicht oder in mehreren Schichten aufgebracht wird, wobei das aufgebrachte Material von der Abstreifplatte abgestreift wird, wobei eine Negativform der Abstreifplatte während eines Erstarrens des Materials auf das Material übertragen wird.

Die Erfindung eignet ich besonders gut für das Drucken von elektrischen und/oder kommunikativen Verbindungen, insbesondere Leiterbahnen, auf einer Rückwand eines Schaltschranks.

Vorteilhaft wird das Material mittels Schmelzschichtung, vorzugsweise Fused Deposition Modeling oder Fused Filament Fabrication, aufgebracht.

Das Verfahren ist besonders kostengünstig.

Besonders günstig ist es, wenn das aufgeschmolzene Material in nur einer Schicht aufgetragen wird, da sich dadurch eine Durchlaufzeit verringert.

Vorteilhaft wird das Material als flüssige Schmelze aufgebracht.

Auf diese Weise kann eine gute Verbindung von Material und Grundfläche erreicht werden. Zudem kann beim Abstreifen eine besonders glatte Oberfläche erreicht werden.

Vorteilhaft wird das Material derart aufgebracht, dass Bahnen gebildet werden.

Die Bahnen können in einem Zug aufgetragen und abgestreift werden. Dies ist besonders vorteilhaft für Leiterbahnen.

Vorteilhaft ist eine Ausführung, wonach das Material wenigstens einen elektrisch leitfähigen Materialanteil aufweist ist.

Vorzugsweise beträgt der elektrisch leitfähige Materialanteil wenigstens 90% eines Gesamtmaterialanteils.

Das Material ist vorzugsweise in Form eines Drahtes verfügbar und wird während des Aufbringens erwärmt bzw. erhitzt, derart, dass es flüssig ist und das Aufbringen auf die Rückwand gut gelingt.

Auch eine zähflüssige oder dickflüssige Form ist denkbar.

Vorteilhaft weist das Material Metall auf, vorzugsweise Lötzinn und/oder Aluminium und/oder Kupfer.

Durch das direkte Auftragen auf die Rückwand kann eine gute Entwärmung erreicht werden. Ein Berührungsschutz kann anschließend aufgebracht werden.

Vorteilhaft ist zudem eine Ausführung, wonach das Material gänzlich ein elektrisch leitfähiges Material ist.

Dies bietet den Vorteil, dass beispielsweise kein Sintern nötig ist. Das Material kann somit die Aufgabe einer Leiterbahn übernehmen.

Dies bietet den Vorteil, dass beispielsweise ein elektrische und/oder kommunikative Verbindung gut gelingt.

Vorteilhaft wird eine elektrische und/oder kommunikative Verbindung zwischen wenigstens zwei in einem Schaltschrank angeordneten Komponenten zur Übertragung elektrischer Energie bzw. zum Transport von Daten hergestellt, wobei die Grundplatte eine Rückwand des Schaltschranks ist, wobei die elektrische und/oder kommunikative Verbindung durch Aufbringen des Materials auf die Rückwand geschaffen wird.

Die Lösung der Aufgabe gelingt zudem durch eine elektrische und/oder kommunikative Verbindung, hergestellt nach dem beschriebenen Verfahren.

Wie bereits weiter oben erläutert ist das Material beim Aufbringen vorteilhaft flüssig oder zähflüssig oder dickflüssig, jedoch nicht fest.

Vorteilhaft wurde das Material erwärmt, um eine gewünschte Viskosität zu erreichen. Das Material ist vorteilhaft derart viskos, dass es beim Aufbringen nicht ungehindert wegfließt, sondern Bahnen gebildet werden können.

Die Verbindung ist somit flexibel und günstig herzustellen.

Die Verbindung und die Rückwand sind vorzugsweise stoffschlüssig verbunden.

In anderen Worten kann die Erfindung wie folgt beschrieben werden: Die Abstreifplatte drückt vorteilhaft die von der Düse extrudierte Schmelze nach unten, bis die Schmelze aufgrund der Abkühlung erstarrt. Mit dem Erstarrungsprozess nimmt die entstehende Oberseite der Schmelze die Negativform der Abstreifplatte an. Durch gezielte Materialauswahl und Oberflächengüte der Abstreifplatte können so spiegelglatte Oberflächen erzeugt werden. Die Abstreifplatte berührt die Düse und weist vorteilhaft ein Material auf, welches sich nur schwer bzw. sehr langsam erwärmt.

Im Folgenden wird die Erfindung anhand der in den Figuren dargestellten Ausführungsbeispiele näher beschrieben und erläutert. Es zeigen:
- FIG 1: einen 3D-Drucker während des Aufbringens eines Materials,
- FIG 2-6 und 9: Ausgestaltungen einer Abstreifplatte,
- FIG 7: einen Schaltschrank,
- FIG 8: Verfahrensschritte.

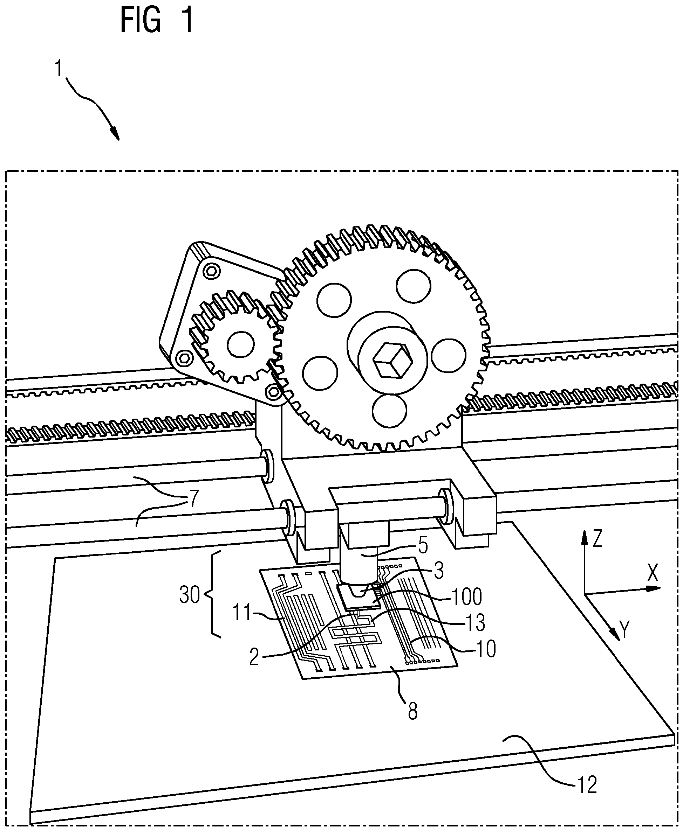

FIG 1 zeigt einen 3D-Drucker 1 während des Aufbringens eines Materials 2.

Die Figur zeigt einen Arbeitstisch 12.

Das Material ist vorzugsweise gut elektrisch leitfähig und ist beispielsweise Lötzinn und/oder Aluminium und/oder Kupfer.

Das Material 2 wird mittels eines Heizelements erwärmt und durch eine Düse 3 auf eine Grundfläche 10 aufgetragen. Das Heizelement ist vorzugsweise in einem Reservoir 5 angeordnet.

Die Düse 3 weist vorteilhaft eine formgebende Öffnung auf. Vorteilhaft wird das Material aus der Düse extrudiert.

Es können mehrere Schichten des Materials aufgetragen werden, um eine gewünschte Dicke der Verbindung zu erreichen.

Vorteilhaft wird jedoch nur eine Schicht aufgetragen. Dies spart Zeit.

Die Figur zeigt drei Achsen X, Y und Z. Ein Verfahrweg 7 ist gezeigt.

Die erfindungsgemäße Einheit zum Auftragen und Abstreifen von Material ist mit dem Bezugszeichen 30 gekennzeichnet. Die Einheit 30 weist auf:
- eine Auftragevorrichtung mit der Düse 3 zum Heraustreiben des Materials 2 aus dem Reservoir 5,
- die Grundfläche 10, ausgebildet zur Ablage des Materials 2,
- eine Abstreifplatte 100, wobei die Abstreifplatte 100 die Düse 3 tangiert.

Mittels der gezeigten Einheit 30 können die Bahnen 11, 13 gut hergestellt werden.

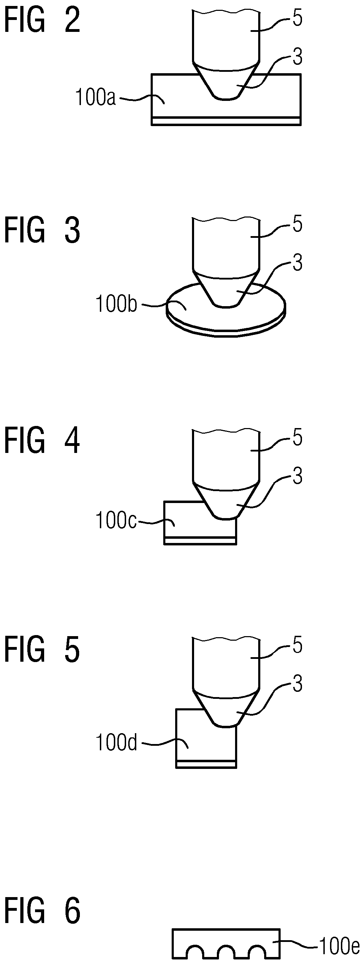

FIG 2 bis 6 zeigen Ausgestaltungen einer Abstreifplatte 100, 100a, 100b, 100c, 100d, 100e, 100f.

Die Abstreifplatte 100, 100a, 100b, 100c, 100d, 100f ist vorteilhaft eine Glätteplatte, sie ist an der Düse angeordnet bzw. mit der Düse 3 verbunden und glättet die von der Düse extrudierte Schmelze gleich nach dem Auftragen.

Sie ist beispielsweise so geformt, dass sie bei jeder Bewegungsrichtung der Düse 3 die Schmelze glätten kann, also auch bei Ecken.

Die Abstreifplatte 100, 100a, 100b, 100c, 100d, 100f kann auch als Abziehplatte bezeichnet werden. Vorteilhaft wird eine Oberfläche der Schmelze abgezogen und somit geglättet bzw. mit einer Struktur oder einem Profil versehen (s. FIG 6).

Alternativ kann auch der Arbeitstisch gedreht werden, um Ecken zu bewerkstelligen und beispielsweise mit der einfachen Abstreifplatte 100d abzustreifen. Auch ein Drehen der Düse 3 samt Abstreifplatte oder ein Drehen der Abstreifplatte ist möglich.

Die Abstreifplatte 100e ist eine strukturierte Abstreifplatte.

Vorteilhaft ist die Abstreifplatte 100, 100a, 100b, 100c, 100d, 100e, 100f derart ausgebildet, dass sie extrudiertes Material 2 unmittelbar nach der Extrusion abstreift.

Sie kann hierzu in Richtung eines Verfahrweges der Düse 3 hinterhergezogen werden (s. z.B. 4 und 5). Um auch mäanderförmige Bahnen drucken zu können ist auch eine runde Ausgestaltung (s. FIG 3) oder die in FIG 2 gezeigte Ausgestaltung möglich.

FIG 6 zeigt von vorne betrachtet eine strukturierte Abstreifplatte 100e. Sie weist Riefen auf. Dies ist beispielsweise von Vorteil, wenn die gedruckte Bahn für hohe Ströme genutzt werden soll, da dadurch eine gute Entwärmung gegeben ist.

FIG 9 zeigt eine glatte Abstreifplatte 100f. Diese eignet sich beispielsweise für gewöhnliche Anwendungen ohne besonders hohe Ströme. Sie bietet den Vorteil, dass eine gute Kontaktierung erreicht werden kann.

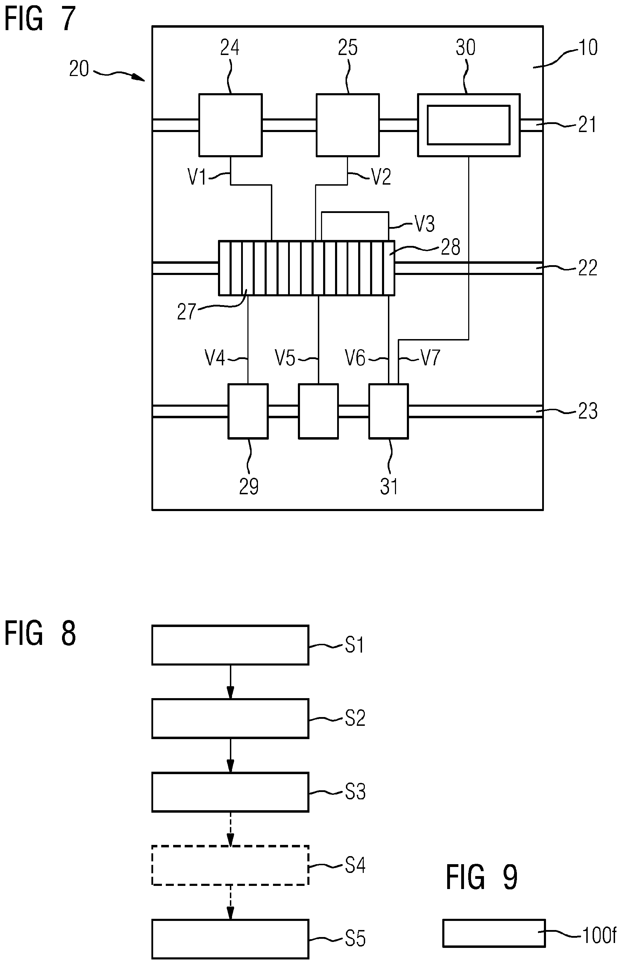

FIG 7 zeigt einen Schaltschrank 20. Der Schaltschrank 20 weist eine Rückwand auf. Die Rückwand ist vorteilhaft die Grundfläche 10, wie bereits in FIG 1 erläutert.

Der Schaltschrank 20 beinhaltet die Racks 21, 22 und 23, an welchen mehrere Komponenten 24, 25, 27, 28, 29, 30 angeordnet sind.

In der Figur sind mehrere Verbindungen V1...7 gezeigt, die mittels des beschriebenen Verfahrens (s. FIG 8) und der beschriebenen Einheit 30 (s. FIG 1) hergestellt wurden. Die Verbindungen verbinden Komponenten elektrisch und/oder kommunikativ. Es werden also elektrische Energie und/oder Daten transportiert. Die Verbindungen können als Leiterbahnen bezeichnet werden.

Beispiel: Die Komponente 25 ist ein Netzteil, welches mit der Komponente 28, die eine Sicherung ist, elektrische verbunden ist. Die Komponente 28 und die Komponente 31 sind elektrisch verbunden, wobei die Komponente 31 eine Steuereinheit ist. Die Komponente 30 ist in diesem Beispiel ein Touchscreen. Die Komponente 30 und die Komponente 31 sind elektrisch und kommunikativ verbunden, vergleichbar zu einem Bus, welcher den Austausch von Daten und Energie ermöglicht.

Die Verbindungen V1...V7 sind beispielsweise die in FIG 1 gedruckten Bahnen 12 und 13.

An den jeweiligen Enden der elektrischen und/oder kommunikativen Verbindung ist vorteilhaft ein geeignetes Kontaktierungselement 8 ausgebildet zur Kontaktierung der jeweiligen Komponente.

Eine Kontaktierung gelingt beispielsweise mittels eines Federkontakts. Vorteilhaft ist der Federkontakt an der Komponente angeordnet. Federkontakt und Komponente sind dann vorteilhaft einteilig.

Alternativ kann der Federkontakt ein einzelnes Bauteil sein, das beispielsweise an die Komponente steckbar ausgeführt ist.

FIG 8 zeigt Verfahrensschritte.

In einem Verfahrensschritt S1 erfolgt eine Bereitstellung der Grundfläche.

In einem Verfahrensschritt S2 wird das Material erwärmt.

Das Material S3 wird in einem Verfahrensschritt S3 auf die Rückwand aufgebracht.

In einem optionalen Verfahrensschritt S4 wird eine weitere Schicht des Materials oder mehrere weitere Schichten des Materials aufgetragen.

In einem Verfahrensschritt S5 erfolgt ein Abstreifen mit der Abstreifplatte. Das Material erstarrt hierbei und nimmt eine Negativform der Abstreifplatte an.

Durch das Erstarren bzw. Abkühlen wird das Material vorteilhaft fest bzw. hart.

## Patentansprüche

1. Einheit (30) zum Auftragen und Abstreifen von Material (2), aufweisend:
- eine Auftragevorrichtung mit einer Düse (3) zum Heraustreiben des Materials (2) aus einem Reservoir (5),
- eine Grundfläche (10), ausgebildet zur Ablage des Materials (2),
- eine Abstreifplatte (100), wobei die Abstreifplatte (100) die Düse (3) tangiert.

2. Abstreifplatte (100) für eine Einheit (30) nach Anspruch 1, aufweisend Glas, insbesondere Quarzglas und/oder Keramik und/oder Metall.

3. Abstreifplatte (100) nach Anspruch 2, wobei die Abstreifplatte (100) wenigstens im Wesentlichen parallel zur Grundfläche (10) angeordnet ist.

4. Abstreifplatte (100) nach einem der Ansprüche 2 oder 3, wobei die Abstreifplatte (100) ein schlecht wärmeleitendes Material aufweist.

5. Abstreifplatte (100) nach einem der Ansprüche 2 bis 4, wobei die Abstreifplatte (100) eine glatte Platte oder eine Platte mit Struktur ist.

6. Verfahren zum Auftragen und Abstreifen von Material (2) mit einer Einheit (30) nach Anspruch 1,
wobei aufgeschmolzenes Material (2) durch eine Düse (3) auf eine Grundfläche (10) in einer Schicht oder in mehreren Schichten aufgebracht wird, wobei das aufgebrachte Material (2) von der Abstreifplatte (100) abgestreift wird, wobei eine Negativform der Abstreifplatte (100) während eines Erstarrens des Materials (2) auf das Material (2) übertragen wird.

7. Verfahren nach Anspruch 6, wobei das Material (2) mittels Schmelzschichtung, vorzugsweise Fused Deposition Modeling oder Fused Filament Fabrication, aufgebracht wird.

8. Verfahren nach einem der Ansprüche 6 oder 7, wobei das Material (2) als flüssige Schmelze aufgebracht wird.

9. Verfahren nach einem der Ansprüche 6 bis 8, wobei das Material (2) derart aufgebracht wird, dass Bahnen gebildet werden.

10. Verfahren nach einem der Ansprüche 6 bis 9, wobei das Material (2) Metall aufweist.

11. Verfahren nach einem der Ansprüche 6 bis 10, wobei das Material (2) Lötzinn und/oder Aluminium und/oder Kupfer aufweist.

12. Verfahren nach einem der Ansprüche 6 bis 11, wobei eine elektrische und/oder kommunikative Verbindung (V1, V2, V3, V4, V5, V6, V7) zwischen wenigstens zwei in einem Schaltschrank (20) angeordneten Komponenten (24, 25, 27, 28, 29, 30, 31) zur Übertragung elektrischer Energie bzw. zum Transport von Daten hergestellt wird, wobei die Grundfläche eine Rückwand (10) des Schaltschranks (20) ist, wobei die elektrische und/oder kommunikative Verbindung (24, 25, 27, 28, 29, 30, 31) durch Aufbringen des Materials (2) auf die Rückwand (10) geschaffen wird.

13. Elektrische und/oder kommunikative Verbindung (V1, V2, V3, V4, V5, V6, V7), hergestellt nach einem Verfahren nach einem der Ansprüche 6 bis 12.
